# EUROPEAN PATENT APPLICATION

(11) **EP 4 692 428 A1**
(43) Date of publication of application: **11.02.2026**
(21) Application number: 24784914.4
(22) Date of filing: 02.04.2024
(51) Int. Cl.: C30B 29/04

(54) **SYNTHETIC SINGLE CRYSTAL DIAMOND, METHOD FOR PRODUCING SYNTHETIC SINGLE CRYSTAL DIAMOND, AND DIAMOND SUBSTRATE**

(30) Priority: 03.04.2023 JP 2023060359
(71) Applicant: Sumitomo Electric Industries, Ltd., Osaka-shi, Osaka 541-0041 (JP)
(72) Inventor: SUMIYA, Hitoshi, Osaka-shi, Osaka 541-0041 (JP); ZUO, Yikang, Osaka-shi, Osaka 541-0041 (JP); TERAMOTO, Minori, Osaka-shi, Osaka 541-0041 (JP)
(74) Representative: Boult Wade Tennant LLP
(86) International application number: PCT/JP2024/013624
(87) International publication number: WO 2024/210130

(57) **Abstract**

Provided is a synthetic single crystal diamond having a nitrogen content, in terms of the number of nitrogen atoms, of 10 ppm or less and a boron content, in terms of the number of boron atoms, of 0.001-3 ppm, wherein the insulation resistance of the synthetic single crystal diamond is 1 MΩ or more.

## Description

### TECHNICAL FIELD

The present disclosure relates to a synthetic single-crystal diamond, a method of manufacturing a synthetic single-crystal diamond, and a diamond substrate. This application claims priority based on Japanese Patent Application No. 2023-060359 filed on April 3, 2023. The entire contents of the Japanese patent application are incorporated herein by reference.

### BACKGROUND ART

As a material of a substrate used in manufacturing a semiconductor diamond, a single crystal diamond is utilized. Hereinafter, a substrate formed of single crystal diamond is also referred to as a "diamond substrate". As a diamond substrate used for manufacturing a semiconductor diamond, a diamond substrate having a high purity and a high crystallinity with less structural defects such as strain and dislocation is suitable.

In Patent Literature 1 (Japanese Unexamined Patent Application Publication No. 2004-331446), a high-purity, high-crystallinity type IIa diamond synthesized at high temperature and high pressure is used as a substrate for producing a semiconductor single crystal diamond.

### CITATION LIST

### PATENT LITERATURE

Patent literature 1: Japanese Unexamined Patent Application Publication No. 2004-331446

### SUMMARY OF INVENTION

A synthetic single-crystal diamond of the present disclosure is a synthetic single-crystal diamond having a nitrogen content on an atomic basis of 10 ppm or less and a boron content on an atomic basis of 0.001 ppm to 3 ppm. The synthetic single-crystal diamond has an insulation resistance of 1 MΩ or more.

### BRIEF DESCRIPTION OF THE DRAWINGS

[FIG. 1] FIG. 1 is a schematic cross-sectional view showing an example of a sample chamber configuration used for manufacturing a synthetic single-crystal diamond according to an embodiment of the present disclosure.
[FIG. 2] FIG. 2 is a diagram showing an example of an infrared absorption spectrum indicating that no absorption peak is observed in a wavenumber range of 2790 cm⁻¹ to 2810 cm⁻¹.

### DETAILED DESCRIPTION

### [Problems to be Solved by the Present Disclosure]

In the IIa type diamond synthesized at high temperature and high pressure, a trace amount of boron is often incorporated into the crystal lattice of the IIa type diamond as an isolated substitutional impurity. Boron is derived from an unavoidable boron impurity contained in a carbon source or a solvent metal used when synthesizing the type IIa diamond by the high-temperature and high-pressure synthesis method. When boron is incorporated into the crystal lattice of the type IIa diamond as an isolated substitutional impurity, a plus charge is generated in the type IIa diamond, and the type IIa diamond becomes a P-type semiconductor and becomes conductive. On the other hand, in the use of a diamond substrate or a heat sink, a diamond having high insulation resistance is desired.

Thus, the present disclosure is directed to providing a synthetic single-crystal diamond having high insulation resistance.

### [Advantageous Effects of Present Disclosure]

According to the present disclosure, it is possible to provide a synthetic single-crystal diamond having high insulation resistance.

### [Description of Embodiments of Present Disclosure]

First, embodiments of the present disclosure will be listed and described.
(1) A synthetic single-crystal diamond of the present disclosure is a synthetic single-crystal diamond having a nitrogen content on an atomic basis of 10 ppm or less and a boron content on an atomic basis of 0.001 ppm to 3 ppm. The synthetic single-crystal diamond has an insulation resistance of 1 MΩ or more.
   According to the present disclosure, it is possible to provide a synthetic single-crystal diamond having high insulation resistance.
(2) In the above (1), the boron content on an atomic basis of the synthetic single-crystal diamond may be 0.01 ppm to 3 ppm. According to this, a single crystal diamond having a low nitrogen content and a low content of inclusions including a nitrogen getter can be synthesized, and a synthetic single-crystal diamond having good quality can be obtained.
(3) In the above (1) or (2), in an infrared absorption spectrum of the synthetic single-crystal diamond measured by Fourier transform infrared spectroscopy, no absorption peak may be observed in a wavenumber range of 2790 cm⁻¹ to 2810 cm⁻¹. Thus, the insulation resistance of the synthetic single-crystal diamond is further increased.
(4) A method of manufacturing the synthetic single-crystal diamond of the present disclosure is a method of manufacturing the synthetic single-crystal diamond described in any one of the above (1) to (3) includes synthesizing a diamond single crystal having a nitrogen content on an atomic basis of 10 ppm or less and a boron content on an atomic basis of 0.001 ppm to 3 ppm by a temperature gradient method using a solvent metal, and irradiating the diamond single crystal with one or both of an electron beam and a corpuscular beam configured to impart an energy of 1 MGy or more and less than 10 MGy to obtain the synthetic single-crystal diamond.
   According to the present disclosure, it is possible to provide a synthetic single-crystal diamond having high insulation resistance.
(5) In irradiating of the above (4), an energy of 1 MGy or more and less than 10 MGy may be imparted to the diamond single crystal by irradiating the diamond single crystal with the electron beam at an energy of 1.0 MeV to 10 MeV and a dose of 1.0 × 10¹⁹ e/m² to 1.0 × 10²¹ e/m².
(6) A diamond substrate of the present disclosure is a diamond substrate formed of the synthetic single-crystal diamond according to any one of the above (1) to (3). The diamond substrate of the present disclosure is suitable as a substrate for manufacturing a semiconductor diamond.

### [Details of Embodiments of Present Disclosure]

Specific examples of the synthetic single-crystal diamond, the method of manufacturing a synthetic single-crystal diamond, and the diamond substrate of the present disclosure will be described below with reference to the drawings. In the drawings of the present disclosure, the same reference numerals represent the same or corresponding parts. In addition, dimensional relationships such as length, width, thickness, and depth are appropriately changed for clarification and simplification of the drawings, and do not necessarily represent actual dimensional relationships.

In the present specification, a notation in the form of "A to B" means the upper limit and the lower limit of a range (that is, A or more and B or less), and in a case where there is no description of a unit in A and a unit is described only in B, the unit of A and the unit of B are the same.

In the present disclosure, when one or more numerical values are listed as the lower limit and the upper limit of a numerical range, the combination of any one numerical value listed in the lower limit and any one numerical value listed in the upper limit is also disclosed. For example, when al or more, b1 or more, and c1 or more are described as the lower limits and a2 or less, b2 or less, and c2 or less are described as the upper limits, then, a1 to a2, a1 to b2, a1 to c2, b1 to a2, b1 to b2, b1 to c2, c1 to a2, c1 to b2 and c1 to c2 are disclosed.

### [Embodiment 1: Synthetic Single-crystal Diamond]

A synthetic single-crystal diamond according to one embodiment of the present disclosure (hereinafter, also referred to as "embodiment 1") is a synthetic single-crystal diamond having a nitrogen content (hereinafter, also referred to as "nitrogen content") on an atomic basis of 10 ppm or less and a boron content (hereinafter also referred to as "boron content") on an atomic basis of 0.001 ppm to 3 ppm. The insulation resistance of the synthetic single-crystal diamond is 1 MΩ or more.

The synthetic single-crystal diamond of embodiment 1 can have high insulation resistance. Furthermore, the synthetic single-crystal diamond of embodiment 1 has a nitrogen content on an atomic basis of 10 ppm or less and a boron content on an atomic basis of 0.001 ppm to 3 ppm, and has few structural defects such as strain and dislocation, and is highly pure and highly crystalline. In the present disclosure, high purity means that the nitrogen content on an atomic basis is 10 ppm or less, and the boron content on an atomic basis is 0.001 ppm to 3 ppm. Thus, the synthetic single-crystal diamond of embodiment 1 is suitable for use as a substrate material or a heat sink used in the manufacturing of a semiconductor diamond.

### <Nitrogen Content on Atomic Basis>

The nitrogen content of the synthetic single-crystal diamond of embodiment 1 is 10 ppm or less. According to this, the synthetic single-crystal diamond has few structural defects such as strain and dislocation, and is likely to have high purity and high crystallinity. In addition, the synthetic single-crystal diamond is likely to have high insulation resistance. The upper limit of the nitrogen content of the synthetic single-crystal diamond is 10 ppm or less, may be 5 ppm or less, may be 1 ppm or less, may be 0.8 ppm or less, may be 0.05 ppm or less, may be 0.04 or less, may be 0.03 ppm or less, and may be 0.02 ppm or less. The lower limit of the nitrogen content of the synthetic single-crystal diamond is not particularly limited, and may be 0 ppm or more, or may be 0.008 ppm or more. The nitrogen content of the synthetic single-crystal diamond may be 0 ppm to 10 ppm, 0.008 ppm to 10 ppm, 0 ppm to 0.8 ppm, or 0.008 ppm to 0.8 ppm.

The nitrogen content of the synthetic single-crystal diamond is measured by secondary ion mass spectrometry (SIMS) using "IMS-7f" (trade name) manufactured by CAMECA as a measurement apparatus and using Cs⁺ ions of 15.0 keV as a primary ion beam.

### <Boron Content on Atomic Basis>

The boron content on an atomic basis of the synthetic single-crystal diamond of embodiment 1 is 0.001 ppm to 3 ppm. According to this, the synthetic single-crystal diamond has few structural defects such as strain and dislocation, and is likely to have high purity and high crystallinity. In addition, the synthetic single-crystal diamond is likely to have high insulation resistance. The upper limit of the boron content of the synthetic single-crystal diamond is 3 ppm or less, may be 2.3 ppm or less, may be 1.5 ppm or less, may be 0.5 ppm or less, may be 0.21 ppm or less, may be 0.19 ppm or less, and may be 0.11 ppm or less. The lower limit of the boron content of the synthetic single-crystal diamond is 0.001 ppm or more, may be 0.01 ppm or more, and may be 0.05 ppm or more. The boron content of the synthetic single-crystal diamond is 0.001 ppm to 3 ppm, may be 0.001 ppm to 2.3 ppm, may be 0.001 ppm to 1.5 ppm, may be 0.01 ppm to 3 ppm, and may be 0.01 ppm to 2.3 ppm.

The boron content of the synthetic single-crystal diamond is measured by secondary ion mass spectrometry (SIMS). A specific measurement method is the same as the above-described method of measuring the nitrogen content of the synthetic single-crystal diamond.

The synthetic single-crystal diamond of embodiment 1 may contain impurities other than nitrogen and boron. Examples of the impurity include hydrogen. The total content of the impurity other than nitrogen and boron in the synthetic single-crystal diamond of embodiment 1 on an atomic basis may be 10 ppm or less.

### <Measurement of Insulation Resistance>

The insulation resistance of the synthetic single-crystal diamond of embodiment 1 is 1 MΩ or more. In the present disclosure, the insulation resistance of the synthetic single-crystal diamond being 1 MΩ or more means that the synthetic single-crystal diamond has high insulation resistance.

The insulation resistance of the synthetic single-crystal diamond is measured by a two terminal measurement method using, for example, an analog insulation resistance meter PDM509S of Sanwa electric meter. The size of the measurement sample can be appropriately set according to the size of the synthetic single-crystal diamond. For example, the sample for measurement can be prepared by processing a synthetic single-crystal diamond into a plate shape having a size of 5 mm square and a thickness of 1 mm. The measurement is carried out at room temperature (20°C ±2°C).

### <Infrared Absorption Spectrum>

In an infrared absorption spectrum of the synthetic single-crystal diamond of embodiment 1 measured by Fourier transform infrared spectroscopy, no absorption peak may be observed in a wavenumber range of 2790 cm⁻¹ to 2810 cm⁻¹. The absorption peak in the wavenumber range of 2790 cm⁻¹ to 2810 cm⁻¹ is derived from an isolated substitutional boron atom having a plus (+) charge. The synthetic single-crystal diamond having a plus (+) charge becomes a P-type semiconductor, and conductivity is generated. In the synthetic single-crystal diamond in which no absorption peak is observed in the wavenumber range of 2790 cm⁻¹ to 2810 cm⁻¹, conductivity derived from isolated substitutional boron atoms having a plus (+) charge is not generated, and thus the insulation resistance is further increased.

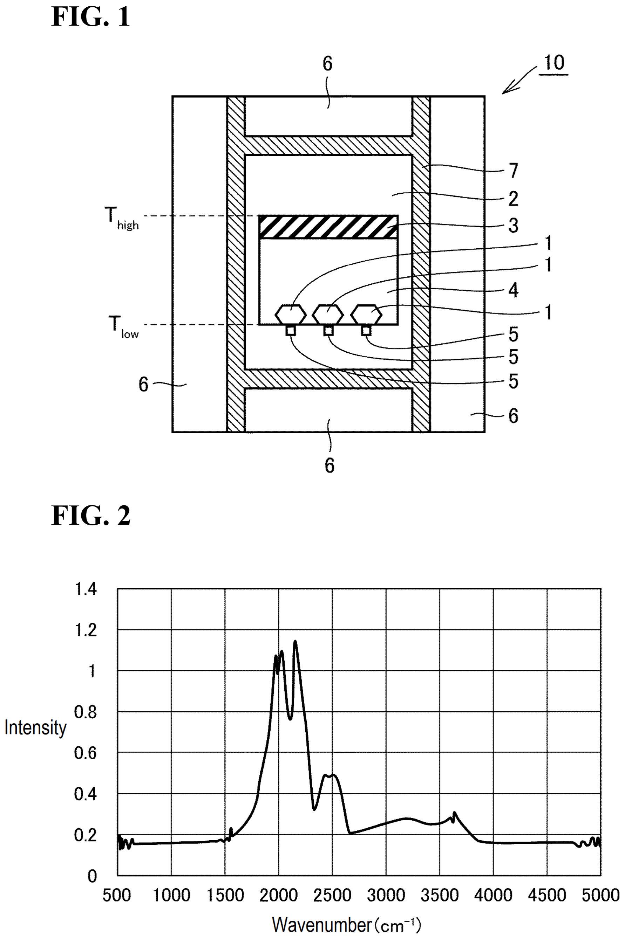

In the present disclosure, the phrase "no absorption peak is observed in a wavenumber range of 2790 cm⁻¹ to 2810 cm⁻¹ in an infrared absorption spectrum" means that no absorption other than the absorption spectrum inherent to diamond is observed in the spectrum of the wavenumber range. This means that there is no maximum value in the wavenumber range of 2790 cm⁻¹ to 2810 cm⁻¹ in the infrared absorption spectrum from a macroscopic point of view. The absorption spectrum inherent to diamond in the wavenumber range of 2790 cm⁻¹ to 2810 cm⁻¹ corresponds to, for example, the infrared absorption spectrum shown in FIG. 2. In the infrared absorption spectrum of FIG. 2, the horizontal axis represents wavenumber (cm⁻¹) and the vertical axis represents intensity. In the infrared absorption spectrum of FIG. 2, there is no maximum value in the wavenumber range of 2790 cm⁻¹ to 2810 cm⁻¹ from a macroscopic point of view, and no absorbance other than the absorption spectrum inherent to diamond is observed. Thus, it is determined that there is no absorption peak in the wavenumber range of 2790 cm⁻¹ to 2810 cm⁻¹ in the infrared absorption spectrum of FIG. 2.

In the present disclosure, the infrared absorption spectrum of the synthetic single-crystal diamond is obtained by measuring by Fourier transform infrared spectroscopy at a temperature of 23°C ±2°C. The measurement procedure is as follows. A synthetic single-crystal diamond as a measuring sample is processed into a plate shape having a thickness of about 1 mm, and two surfaces through which light is transmitted are polished with a metal-bonded grinding wheel so that the roughness Ra of the surfaces is 20 nm or less. The polished surface is irradiated with infrared rays to create an infrared absorption spectrum. The measurement is performed at a temperature of 23°C ±2°C (21°C to 25°C). Temperature changes of a measuring instrument and a sample during measurement are kept to ±1°C or less.

### [Embodiment 2: Method of Manufacturing Synthetic Single-Crystal Diamond]

A method of manufacturing the synthetic single-crystal diamond according to one embodiment of the present disclosure (hereinafter, also referred to as "embodiment 2") is a method of manufacturing the synthetic single-crystal diamond according to embodiment 1 includes a first step of synthesizing a diamond single crystal having a nitrogen content on an atomic basis of 10 ppm or less and a boron content on an atomic basis of 0.001 ppm to 3 ppm by a temperature gradient method using a solvent metal, a second step of irradiating the diamond single crystal with one or both of an electron beam and a corpuscular beam configured to impart an energy of 1 MGy or more and less than 10 MGy to obtain the synthetic single-crystal diamond.

### <First Step>

In the first step, a diamond single crystal having a nitrogen content on an atomic basis of 10 ppm or less and a boron content on an atomic basis of 0.001 ppm to 3 ppm is synthesized by a temperature gradient method using a solvent metal. For example, a diamond single crystal can be produced by a temperature gradient method using a sample chamber having a configuration shown in FIG. 1.

As shown in FIG. 1, in a sample chamber 10 used for manufacturing a diamond single crystal 1, an insulator 2, a carbon source 3, a solvent metal 4, and a seed crystal 5 are disposed in a space surrounded by a graphite heater 7, and a pressure medium 6 is disposed outside the graphite heater 7. The temperature gradient method is a synthesis method in which a temperature gradient in the vertical direction is provided inside the sample chamber 10, the carbon source 3 is disposed in a high temperature portion (T_{high}), the diamond seed crystal 5 is disposed in a low temperature portion (T_{low}), the solvent metal 4 is disposed between the carbon source 3 and the seed crystal 5, and the diamond single crystal 1 is grown on the seed crystal 5 by maintaining a condition of a temperature equal to or higher than a temperature at which the solvent metal 4 is dissolved and a pressure equal to or higher than a pressure at which the diamond is thermally stabilized. For example, the pressure in the sample chamber is controlled to 5.0 to 6.0 GPa, the temperature of the high temperature portion of the solvent metal is controlled to 1400°C to 1500°C, the temperature of the low temperature portion is controlled to 1360°C to 1380°C, and the temperature is maintained for 50 to 200 hours to grow a diamond single crystal on the seed crystal.

As the carbon source 3, diamond powder is preferably used. As the solvent metal 4, one or more metals selected from iron (Fe), cobalt (Co), nickel (Ni), manganese (Mn), and the like, or an alloy containing these metals can be used. The carbon source 3 may contain boron (B) as an impurity. An affordable and readily available carbon source (diamond powder) contains boron as an impurity in excess of several tens of ppm. Since a diamond single crystal synthesized using such a carbon source contains boron as an impurity, conductivity is generated, and thus, the diamond single crystal cannot be used as a substrate material used when a semiconductor diamond is produced. According to the manufacturing method of embodiment 2, by performing the second step described later on the diamond single crystal, even a synthetic single-crystal diamond containing boron as an impurity has high insulation resistance, and thus can be used as a substrate material used in producing a semiconductor diamond.

The solvent metal 4 may further contain one or more elements selected from the group consisting of titanium (Ti), vanadium (V), chromium (Cr), copper (Cu), zirconium (Zr), niobium (Nb), molybdenum (Mo), ruthenium (Ru), rhodium (Rh), hafnium (Hf), tantalum (Ta), tungsten (W), osmium (Os), iridium (Ir), and platinum (Pt). The solvent metal 4 may contain boron (B) as an impurity.

### <Second Step>

In the second step, the diamond single crystal obtained in the first step is irradiated with one or both of an electron beam and a corpuscular beam configured to impart an energy of 1 MGy or more and less than 10 MGy to obtain the synthetic single-crystal diamond.

The present inventors have newly found that the obtained synthetic single-crystal diamond has high insulation resistance by irradiating the diamond single crystal obtained in the first step with one or both of an electron beam and a corpuscular beam configured to impart an energy of 1 MGy or more and less than 10 MGy (hereinafter, also referred to as "irradiation with an electron beam or the like").

The reason for the above is not clear, but is presumed as follows. By irradiating the diamond single crystal with an electron beam or the like configured to impart an energy of 1 MGy or more and less than 10 MGy, a composite of vacancies (V) is formed in the crystal lattice of the synthetic single-crystal diamond, and a minus (-) charge is generated in the synthetic single-crystal diamond. The minus (-) charge compensates for the plus (+) charge of the isolated substituted boron atom. It is inferred that this reduces the conductivity of the synthetic single-crystal diamond, and the synthetic single-crystal diamond has high insulation resistance.

When the energy amount to be irradiated is less than 1 MGy, the formation of the composite of the vacancy (V) may be insufficient. When the energy amount is 10 MGy or more, an excessive vacancy may be generated and crystallinity may be deteriorated. Thus, the energy amount is preferably 1 MGy or more and less than 10 MGy.

As the corpuscular beam, a neutron beam or a proton beam can be used. The radiation conditions are not particularly limited as long as an energy of 1 MGy or more and less than 10 MGy can be applied to the diamond single crystal. The radiation conditions may be conditions that can provide an energy of 1 MGy to 5 MGy to the diamond single crystal.

In the second step, the diamond single crystal obtained in the first step may be processed to have a thickness of 0.1 mm to 10 mm in the case of a size of 10 mm square, for example. In this case, the conditions for irradiating the electron beam can be, for example, an energy of the electron beam of 1.0 MeV to 10 MeV, and a dose of 1.0 × 10¹⁹ e/m² to 1.0 × 10²¹ e/m². The area irradiated with the electron beam is larger than the surface (region) of the diamond single crystal irradiated with the electron beam.

### [Embodiment 3: Diamond Substrate]

A diamond substrate according to one embodiment of the present disclosure (hereinafter, also referred to as "embodiment 3") is a diamond substrate formed of the synthetic single-crystal diamond described in embodiment 1. The diamond substrate of embodiment 1 has high insulation resistance, and is thus suitable as a substrate for producing a semiconductor diamond.

### [Examples]

The present embodiment will be described more specifically with reference to examples. However, the present embodiment is not limited to these examples.

### <Production of Synthetic Single-Crystal Diamond>

### <<First Step>>

Using a sample chamber having the configuration shown in FIG. 1, a diamond single crystal of each sample was synthesized by a temperature gradient method using a solvent metal.

An iron-cobalt alloy (Fe-Co alloy) was used as a solvent metal, and titanium (Ti) was added to the solvent metal as a nitrogen getter. The amount of titanium added to the solvent metal in each sample is as shown in the "Ti addition amount" column of "Solvent Metal" of "First Step" in Table 1. For example, "2.0 mass%" of sample 1 indicates that the ratio of the mass of the solvent metal to the addition amount (mass) of titanium is solvent metal: titanium = 100:2. By changing the amount of titanium added to the solvent metal, the nitrogen content in the synthesized diamond single crystal can be adjusted.

As the carbon source, various diamond powders having different boron contents were used. The boron content of the diamond powder used in each sample is as shown in the "B content" column of the "Carbon Source" of the "First step" in Table 1. A diamond single crystal having a size of about 0.5 mm was used as a seed crystal. By adjusting the boron content of the diamond powder, the boron content in the synthesized diamond single crystal can be adjusted.

The temperature in the sample chamber was adjusted by a heater so that a temperature difference of several tens of degrees was generated between a high temperature portion where the carbon source was disposed and a low temperature portion where the seed crystal was disposed. The pressure was controlled to 5.5 GPa and the temperature of the low temperature portion was controlled within the range of 1370°C ±10°C (1360°C to 1380°C) using an ultra-high pressure generating apparatus, and the temperature was maintained for 60 hours to synthesize a diamond single crystal on the seed crystal.

The nitrogen content and the boron content of the diamond single crystal of each sample were measured by SIMS. The specific measurement method is as described in embodiment 1. The results are shown in the columns "N content" and "B content" of "Diamond Single Crystal" in Table 1.

### <<Second Step>>

Next, the obtained diamond single crystal was irradiated with an electron beam that provides an energy of 5 MGy or 1 MGy, thereby obtaining a synthetic single-crystal diamond of each sample. The conditions for irradiating the electron beam were set to an energy of 2 MeV of the electron beam and a dose of 2 × 10²⁰ e/m² when an energy of 5 MGy was given. When an energy of 1 MGy is given, an energy of 2 MeV of the electron beam and a dose of 4 ×10¹⁹ e/m² were set. The diamond single crystal had a size such that the inscribed circle of the main surface had a diameter of about 5 mm. In Table 1, in the samples in which "Not Irradiated" is written in the column of "Electron Beam Irradiation" of "Second Step", the electron beam irradiation was not performed.

**[Table 1]**

| Sample Number | Method of Manufacturing | | | | | |
|---|---|---|---|---|---|---|
| | First Step | | | | Second Step | |
| | Solvent Metal | Carbon Source | Diamond Single Crystal | | Electron Beam Irradiation | |
| | Ti addition amount | B Content | N content | B Content | Irradiated/ Not Irradiated | Energy |
| | mass% | ppm | ppm | ppm | | MGy |
| 1 | 2. 0 | 5 | 0.008 | 0. 050 | Not Irradiated | - |
| 2 | 2. 0 | 5 | 0. 008 | 0.050 | Irradiated | 5 |
| 3 | 1.5 | 10 | 0.020 | 0. 110 | Not Irradiated | - |
| 4 | 1.5 | 10 | 0.020 | 0.110 | Irradiated | 5 |
| 5 | 1. 3 | 20 | 0.040 | 0.190 | Not Irradiated | - |
| 6 | 1. 3 | 20 | 0.040 | 0. 190 | Irradiated | 5 |
| 7 | 1.2 | 20 | 0. 050 | 0.210 | Not Irradiated | - |
| 8 | 1.2 | 20 | 0. 050 | 0. 210 | Irradiated | 5 |
| 9 | 1. 4 | 150 | 0.030 | 1. 500 | Not Irradiated | - |
| 10 | 1.4 | 150 | 0.030 | 1. 500 | Irradiated | 5 |
| 11 | 0.9 | 250 | 0. 800 | 2. 300 | Not Irradiated | - |
| 12 | 0.9 | 250 | 0. 800 | 2. 300 | Irradiated | 5 |
| 13 | 0. 7 | 0. 1 | 1. 000 | 0.001 | Irradiated | 5 |
| 14 | 0.4 | 1 | 5.000 | 0. 010 | Irradiated | 5 |
| 15 | 0.2 | 550 | 10. 000 | 5. 000 | Irradiated | 5 |
| 16 | 0.2 | 320 | 10.000 | 3. 000 | Irradiated | 1 |

### <Evaluation>

The synthetic single-crystal diamond of each sample was subjected to measurement of nitrogen content and boron content, measurement of insulation resistance, and analysis by infrared spectroscopy.

### <<Measurement of Nitrogen Content and Boron Content>>

The nitrogen content and boron content of the synthetic single-crystal diamond of each sample were measured by SIMS. Specific measurement conditions are as described in embodiment 1. In all samples, it was found that the nitrogen content and the boron content of the synthetic single-crystal diamond were the same as the nitrogen content and the boron content of the diamond single crystal described in Table 1. The content of an impurity other than nitrogen and boron in the synthetic single-crystal diamond of each sample was measured by SIMS, and it was found that the content was 10 ppm or less in all the samples.

### <<Measurement of Insulation Resistance>>

The synthetic single-crystal diamond of each sample was processed into a plate shape having a size of 0.5 mm square and a thickness of 0.1 mm, and the resistance was measured. The specific measurement method is as described in embodiment 1. The results are shown in the "Insulation Resistance" column of "Synthetic Single-Crystal Diamond" in Table 2. The notation "> 10" indicates that the insulation resistance is greater than 10 MΩ and the synthetic single-crystal diamond has a high insulation resistance. The notation "≤ 0.01" indicates that the insulation resistance is 0.01 MΩ or less. When the insulation resistance is described with a range as in "0.2 - 0.5" of sample 1, it indicates that there was a difference in the insulation resistance depending on the contact location of the measurement terminal on the sample surface.

### <<Analysis by Infrared Spectroscopy>>

The synthetic single-crystal diamond of each sample was processed into a plate shape having a thickness of about 1 mm, and two surfaces through which light was transmitted were polished with a metal-bonded grindstone so that the roughness Ra was 20 nm or less, and then an infrared absorption spectrum was prepared using an infrared spectrophotometer.

In the infrared absorption spectrum of each sample, it was found whether an absorption peak was observed in the wavenumber range of 2790 cm⁻¹ to 2810 cm⁻¹. The results are shown in the column of "Wavenumber 2790 - 2810 cm⁻¹ Absorption peak" of "Infrared Absorption Spectrum" of "Synthetic Single-Crystal diamond" in Table 2. In the column, "Observed" indicates that an absorption peak is observed in the range. In the column, "Not observed" indicates that no absorption peak is observed in the range.

**[Table 2]**

| Sample Number | Synthetic Single-Crystal Diamond | |
|---|---|---|
| | Insulation Resistance | Infrared Absorption Spectrum Wavenumber 2790 - 2810 cm⁻¹ Absorption Peak |
| | MΩ | Observed/Not Observed |
| 1 | 0.2-0.5 | Observed |
| 2 | >10 | Not Observed |
| 3 | 0.05-0.1 | Observed |
| 4 | >10 | Not Observed |
| 5 | 0.05-0.1 | Observed |
| 6 | >10 | Not Observed |
| 7 | 0.05-0.1 | Observed |
| 8 | >10 | Not Observed |
| 9 | ≦0.01 | Observed |
| 10 | >10 | Not Observed |
| 11 | ≦0.01 | Observed |
| 12 | >10 | Not Observed |
| 13 | >10 | Not Observed |
| 14 | >10 | Not Observed |
| 15 | 0.3-0.7 | Observed |
| 16 | >10 | Not Observed |

### <Consideration>

Sample 2, sample 4, sample 6, sample 8, sample 10, sample 12 to sample 14, and sample 16 correspond to Examples. It was found that these synthetic single-crystal diamonds have different boron contents, but all have high insulation resistance.

The sample 1, the sample 3, the sample 5, the sample 7, the sample 9, the sample 11, and the sample 15 correspond to comparative examples. In these samples, it is inferred that since nitrogen and boron are non-uniformly dispersed in the diamond crystal, the synthetic single-crystal diamond includes a region where the plus (+) charge of the isolated substitutional boron atom is located, and thus conductivity is generated.

Although the embodiments and examples of the present disclosure have been described above, it is originally intended that the configurations of the above-described embodiments and examples are appropriately combined or modified in various ways. The embodiments and examples disclosed herein are illustrative in all respects and should not be construed as limiting. The scope of the present invention is defined by the scope of the claims, not by the above-described embodiments and examples, and is intended to include any modifications within the scope and meaning equivalent to the scope of the claims.

### REFERENCE SIGNS LIST

1 diamond single crystal, 2 insulator, 3 carbon source, 4 solvent metal, 5 seed crystal, 6 pressure medium, 7 graphite heater, 10 sample chamber

## Claims

1. A synthetic single-crystal diamond having a nitrogen content on an atomic basis of 10 ppm or less and a boron content on an atomic basis of 0.001 ppm to 3 ppm,
wherein the synthetic single-crystal diamond has an insulation resistance of 1 MΩ or more.

2. The synthetic single-crystal diamond according to claim 1, wherein the boron content on an atomic basis of the synthetic single-crystal diamond is 0.01 ppm to 3 ppm.

3. The synthetic single-crystal diamond according to claim 1 or 2, wherein in an infrared absorption spectrum of the synthetic single-crystal diamond measured by Fourier transform infrared spectroscopy, no absorption peak is observed in a wavenumber range of 2790 cm⁻¹ to 2810 cm⁻¹.

4. A method of manufacturing the synthetic single-crystal diamond according to any one of claims 1 to 3, the method comprising:
synthesizing a diamond single crystal having a nitrogen content on an atomic basis of 10 ppm or less and a boron content on an atomic basis of 0.001 ppm to 3 ppm by a temperature gradient method using a solvent metal; and
irradiating the diamond single crystal with one or both of an electron beam and a corpuscular beam configured to impart an energy of 1 MGy or more and less than 10 MGy to obtain the synthetic single-crystal diamond.

5. The method of manufacturing the synthetic single-crystal diamond according to claim 4, wherein in the irradiating, an energy of 1 MGy or more and less than 10 MGy is imparted to the diamond single crystal by irradiating the diamond single crystal with the electron beam at an energy of 1.0 MeV to 10 MeV and a dose of 1.0 × 10¹⁹ e/m² to 1.0 × 10²¹ e/m².

6. A diamond substrate formed of the synthetic single-crystal diamond according to any one of claims 1 to 3.
